Europäisches Patentamt

European Patent Office

Office européen des brevets

(19)

(11) Veröffentlichungsnummer: **0 496 999 A2**

# EUROPÄISCHE PATENTANMELDUNG

(12)

(21) Anmeldenummer: **91121954.1**

(51) Int. Cl.⁵: **H03H 7/48**

(22) Anmeldetag: **20.12.91**

(30) Priorität: **31.01.91 DE 4102930**

(43) Veröffentlichungstag der Anmeldung:
**05.08.92 Patentblatt 92/32**

(84) Benannte Vertragsstaaten:
**DE ES FR GB IT**

(71) Anmelder: **Rohde & Schwarz GmbH & Co. KG
Mühldorfstrasse 15
W-8000 München 80(DE)**

(72) Erfinder: **Dalisda, Uwe, Dipl.-Ing.
Donaustrasse 29d
W-8037 Olching(DE)**

(74) Vertreter: **Graf, Walter, Dipl.-Ing.
Sckellstrasse 1
W-8000 München 80(DE)**

(54) Schaltung zum Aufteilen oder Zusammenführen von Hochfrequenzleistung.

(57) Bei einer Schaltung zum Aufteilen von einem Summentor zugeführter Hochfrequenzleistung auf mehrere Einzeltore bzw. zum Zusammenführen von Einzeltoren zugeführter Hochfrequenzleistung in einem Summentor ist der zwischen den Einzeltoren wirkende Lastausgleichswiderstand durch einen einseitig an Masse geschalteten Absorberwiderstand gebildet, der mit den Einzeltoren über ein Dreitor verbunden ist, das so ausgebildet ist, daß innerhalb des Betriebsfrequenzbereiches die an seinen beiden Eingangstoren anliegenden Signale bezogen auf das gemeinsame Ausgangstor um 180⁰ phasenverschoben sind.

EP 0 496 999 A2

Die Erfindung betrifft eine Schaltung laut Oberbegriff des Hauptanspruches.

Schaltungen dieser Art sind als Brückenschaltungen oder Wilkinson-Koppler bekannt (z.B. nach NTZ 1962, Heft 5, Seiten 223 bis 230 oder DP 27 33 888). Sie werden in der Hochfrequenztechnik vor allem zum Parallelschalten von Hochfrequenzsendern benutzt. Es ist auch bekannt, solche Wilkinson-Koppler ganz oder teilweise aus konzentrierten Bauelementen wie Spulen und Kondensatoren aufzubauen, ferner ist es bekannt, diese die Leitungsstücke nachbildenden konzentrierten Bauelemente des Wilkinson-Kopplers gleichzeitig als Filterschaltung auszubilden und so zu dimensionieren, daß sie gleichzeitig als Hochfrequenzfilter im Signalaufbereitungszug wirken (DE 35 27 555). Bei all diesen bekannten Schaltungen sind immer zusätzliche Lastausgleichswiderstände erforderlich. Dabei sind zusätzliche Lastausgleichswiderstände erforderlich, die sowohl bei den Brückenschaltungen als auch bei den Wilkinson-Kopplern spannungsmäßig hochliegend zwischen Einzeltoren geschaltet sind und durch welche die Differenzleistung aufgenommen wird, die bei eventuellen Betrags- und/oder Phasenfehlern der mit gleicher Frequenz eingespeisten Hochfrequenzleistung entsteht. Der Anschluß dieses Lastausgleichswiderstandes symmetrisch zum Massepotential ist in mehrfacher Hinsicht nachteilig, die Anschlüsse dieses Widerstandes haben in allen Betriebsfällen ein Potential gegen Masse, der Widerstand muß unmittelbar am Eingang der Schaltung angeschlossen werden, seine Anordnung ist also ortsgebunden, die Anschlußinduktivitäten führen ferner dazu, daß der Eingangswiderstand der Schaltung verstimmt wird. Für die Parallelschaltung von Hochfrequenzsendern großer Leistung muß dieser Lastausgleichswiderstand entsprechend groß dimensioniert werden, was eine starke thermische Belastung auf kleinstem Raum bedeutet.

Um diesen Nachteil zu vermeiden wird ausgehend von einer Schaltung laut Oberbegriff des Hauptanspruches eine Anordnung des Lastausgleichswiderstandes gemäß kennzeichnendem Teil des Hauptanspruches vorgeschlagen. Vorteilhafte Weiterbildungen ergeben sich aus den Unteransprüchen.

Die Anordnung des erfindungsgemäßen Lastausgleichswiderstandes ist nicht ortsgebunden, er kann über ein beliebig langes Koaxialkabel an beliebiger Stelle angeordnet werden. Damit sind beliebig große Absorberleistungen realisierbar, da der Widerstand infolge seiner Ortsunabhängigkeit optimal gekühlt werden kann. Es sind auch keine Leistungsverluste durch parasitäre Kapazitäten zu befürchten und der Widerstandswert des Absorberwiderstandes kann beliebig gewählt sein. Die erfindungsgemäße Schaltung ist zwar vor allem von Vorteil für das Parallelschalten von zwei oder mehreren Hochfrequenzsendern beispielsweise auf eine gemeinsame Antenne, ihre vorteilhaften Eigenschaften machen sie jedoch genauso gut geeignet zum Aufteilen von Hochfrequenzleistung auf mehrere Einzeltore.

Die Erfindung wird im folgenden anhand schematischer Zeichnungen an Ausführungsbeispielen näher erläutert.

Die Figuren zeigen verschiedene Möglichkeiten für die Realisierung der erfindungsgemäßen Schaltungen im Zusammenhang mit Wilkinson-Kopplern und zwar zum Parallelschalten von Hochfrequenzsendern gleicher Frequenz, in analoger Weise kann die Erfindung jedoch auch bei Brückenschaltungen der eingangs erwähnten Art angewendet werden.

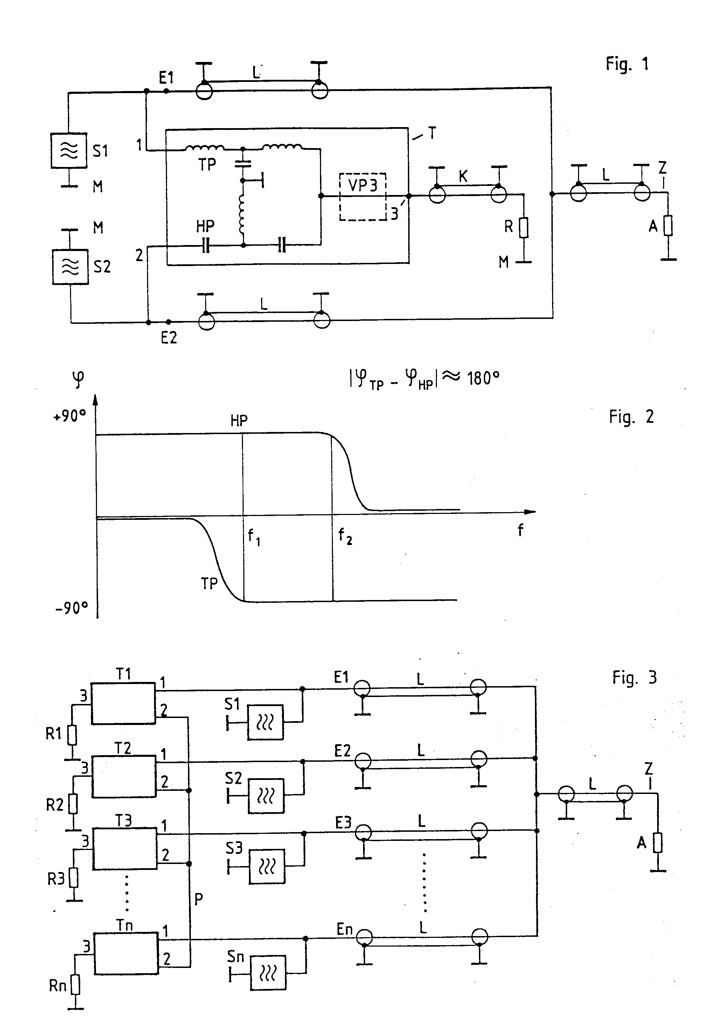

Fig. 1 zeigt das Prinzipschaltbild eines Zweifach-Wilkinson-Kopplers, der aus drei Leitungstransformationsgliedern L von jeweils $\lambda/4$-Länge gebildet ist und zum Zusammenführen der Hochfrequenzleistung von zwei Hochfrequenzsendern $S_1$ und $S_2$ von jeweils gleicher Leistung und gleicher Frequenz in einer gemeinsamen Antenne A dient. Der bei solchen Wilkinson-Kopplern zwischen den Schaltungspunkten 1 und 2 angeordnete Lastausgleichswiderstand wird gemäß der Erfindung durch ein Dreitor T ersetzt, an dessen Ausgang 3 ein Absorberwiderstand R gegen Masse M geschaltet ist. Das Dreitor T ist so ausgebildet und dimensioniert, daß die an seinen beiden Eingangstoren 1 und 2 von den Hochfrequenzsendern S1 und S2 jeweils mit gleicher Frequenz zugeführten Ströme am gemeinsamen Ausgangstor 3 gegenphasig sind, sich bei gleicher Leistung der Hochfrequenzsender an diesem Ausgangstor 3 also gegenseitig aufheben. Nur wenn der Betrag und/oder die Phase der an den Eingangstoren 1 und 2 eingespeisten Ströme infolge unterschiedlicher Leistung der beiden Hochfrequenzsender S1 und S2 unterschiedlich ist können sich die $180^0$ gegeneinander phasenverschobenen Ströme nicht mehr aufheben und der Leistungsunterschied wird in dem Lastausgleichswiderstand R absorbiert. Das Dreitor T ist ferner so dimensioniert, daß diese gewünschte $180^0$-Phasenverschiebung zwischen den Eingangstoren 1 und 2 und dem gemeinsamen Ausgangstor 3 jeweils innerhalb des gesamten Betriebsfrequenzbereiches der Sender zwischen $f_1$ und $f_2$ gewährleistet ist. Die gewünschte $180^0$-Phasenverschiebung in den Dreitor-Zweigen kann beispielsweise durch entsprechende verlustarme Laufzeitglieder erreicht werden, vorzugsweise sind hierzu jedoch unterschiedlich bemessene Filterschaltungen vorgesehen. In dem dargestellten Ausführungsbeispiel besteht das Dreitor T aus einem mehrgliedrigen Hochpaß HP und einem mehrgliedrigen Tiefpaß TP. Die Grenzfrequenzen $f_1$ und $f_2$ dieser beiden Filter HP bzw. TP sind gemäß Fig. 2 so gewählt, daß die zugehörigen Phasenverläufe im vorgegebenen Betriebsfrequenzbereich zwischen $f_1$ und $f_2$ jeweils entgegengesetzt $90^0$ sind, der Hochpaß HP also eine $+90^0$-Phasenverschiebung und der Tiefpaß TP eine entsprechende $-90^0$-Phasenverschiebung erzeugt. Damit wird erreicht, daß die an den Eingangstoren 1 und 2 zugeführten Signale im Verbindungspunkt 3 insgesamt um $180^0$ gegeneinander phasenverschoben sind. Fig. 2 zeigt die Phasenverläufe einfacher Hochpaß- und Tiefpaß-Filter HP bzw. TP, mehrgliedrige steilere Filterschaltungen, wie sie in Fig. 1 dargestellt sind, besitzt im Prinzip ähnliche gegenphasige Phasenverläufe, durch entsprechende Dimensionierung der Grenzfrequenzen und der Bauelemente ist es auch bei solchen mehrgliedrigen Filtern möglich, die in Fig. 2 angegebene Beziehung von insgesamt $180^0$-Phasenverschiebung am Ausgangstor 3 innerhalb des vorgegebenen Betriebsfrequenzbereiches $f_1$ bis $f_2$ beispielsweise im UKW-Bereich zwischen 70 und 150 MHz einzuhalten.

Die beiden Filter TP und HP sind außerdem so dimensioniert, daß der Eingangswiderstand zwischen den beiden Eingangstoren 1 und 2 dem Widerstandswert entspricht, der bei solchen Wilkinson-Kopplern zwischen den beiden Sendern $S_1$ und $S_2$ als Lastausgleichswiderstand wirken soll, also beispielsweise 100 Ohm. Da als Absorberwiderstand R am Ausgangstor 3 des Dreitores T vorzugsweise ein 50 Ohm-Widerstand benutzt wird, können die Filter HP und TP zusätzlich auch noch so dimensioniert sein, daß die gewünschte Widerstandstransformation vom Eingang zum Ausgang entsteht. Der Absorberwiderstand R kann über ein beliebig langes Koaxialkabel K an den Ausgang 3 des Dreitores T angeschaltet sein. Der Widerstand R kann damit an einem beliebigen Ort montiert werden, an welchem die besten Kühlmöglichkeiten für ihn eingesetzt werden können. Es ist lediglich erforderlich, daß jeweils Anpassung zwischen Ausgang 3 und Kabel sowie Absorberwiderstand R und Kabel besteht.

Wenn die gewünschte Anpassung des Eingangswiderstandes nicht bereits durch entsprechende Dimensionierung der Filter HP und TP erreichbar ist, kann zwischen dem gemeinsamen Verbindungspunkt der beiden Filter HP und TP gegebenenfalls noch ein zusätzlicher Transformations-Vierpol VP3 zwischengeschaltet werden, der gewährleistet, daß im gesamten Betriebsfrequenzbereich die gewünschte Widerstandstransformation eingehalten wird.

Fig. 3 zeigt einen Mehrfach-Wilkinson-Koppler zum Zusammenführen der Ausgangsleistung von mehreren mit gleicher Frequenz arbeitenden Hochfrequenzsendern $S_1$ bis $S_n$, der wiederum durch Leitungstransformationsglieder L aufgebaut ist, die Lastausgleichswiderstände sind bei einer solchen Schaltung in einem gemeinsamen Summenpunkt zusammengefaßt. Auch in diesem Ausführungsbeispiel werden die Lastausgleichswiderstände durch Dreitore $T_1$ bis $T_n$ gebildet, an deren Ausgang jeweils ein Absorberwiderstand $R_1$ bis $R_n$ angeschaltet ist, der eine Eingang 1 der Dreitore $T_1$ bis $T_n$ ist jeweils mit einem der Sender $S_1$ bis $S_n$ verbunden während die anderen Eingänge 2 sämtlicher Dreitore in dem Summenpunkt P zusammengefaßt sind. Die Eingangswiderstände dieser Dreitore $T_1$ bis $T_n$ sind wieder nach den bekannten Dimensionierungsvorschriften solcher Mehrfach-Wilkinson-Koppler bemessen, beim Anschluß an einen Sternpunkt z.B. jeweils 50 Ohm. Der Wert der Absorberwiderstände $R_1$ bis $R_n$ kann wieder beliebig sein, auch hier können diese Widerstände wieder über beliebig lange Koaxialkabel an den Ausgang der Dreitore angeschlossen sein, sie können also wieder an beliebigen Stellen montiert werden.

**Patentansprüche**

1. Schaltung zum Aufteilen von einem Summentor (Z) zugeführter Hochfrequenzleistung auf mehrere Einzeltore (E) bzw. zum Zusammenführen von Einzeltoren (E) zugeführter Hochfrequenzleistung in einem Summentor (Z), bei der zwischen den Einzeltoren (E) jeweils ein Lastausgleichswiderstand wirkt, dadurch **gekennzeichnet,** daß der Lastausgleichswiderstand durch einen einseitig an Masse (M) geschalteten Absorberwiderstand (R) gebildet ist, der mit den Einzeltoren ($E_1$ bis $E_n$) über ein Dreitor (T, $T_1$ bis $T_n$) verbunden ist, das so ausgebildet ist, daß innerhalb des Betriebsfrequenzbereiches ($f_1$ bis $f_2$) die an den beiden Eingangstoren (1, 2) anliegenden Signale bezogen auf das gemeinsame Ausgangstor (3) gegenphasig sind.

2. Schaltung nach Anspruch 1, dadurch **gekennzeichnet,** daß das Dreitor (T, $T_1$ bis $T_n$) aus einem zwischen dem einen Eingangstor (1) und dem Ausgangstor (3) geschalteten Tiefpaß (TP) und einem zwischen dem anderen Eingangstor (2) und dem Ausgangstor (3) geschalteten Hochpaß (HP) besteht.

3. Schaltung nach Anspruch 2, dadurch **gekennzeichnet,** daß zwischen dem Verbindungspunkt von Hochpaß und Tiefpaß und dem Ausgangstor (3) ein zusätzlicher Transformationsvierpol (VP3) angeordnet ist.

4. Schaltung nach einem der vorhergehenden Ansprüche, dadurch **gekennzeichnet,** daß der Eingangswiderstand des Dreitores (T, $T_1$ bis

$T_n$) zwischen seinen Eingangstoren (1, 2) dem Wert des jeweils geforderten Lastausgleichswiderstandes entspricht.

5. Schaltung nach einem der vorhergehenden Ansprüche, dadurch **gekennzeichnet,** daß der Wert des an das Ausgangstor (3) des Dreitores ($T$, $T_1$ bis $T_n$) angeschalteten Absorberwiderstandes ($R$, $R_1$ bis $R_n$) beliebig gewählt ist.

6. Schaltung nach einem der vorhergehenden Ansprüche, dadurch **gekennzeichnet,** daß der Absorberwiderstand ($R$, $R_1$ bis $R_n$) über ein Koaxialkabel (K) beliebiger Länge mit dem Ausgangstor (3) des Dreitores verbunden ist.

Fig. 1

$$|\varphi_{TP} - \varphi_{HP}| \approx 180°$$

Fig. 2

Fig. 3